(19) Europäisches Patentamt
European Patent Office
Office européen des brevets

(11) **EP 3 154 194 A1**

(12) **EUROPEAN PATENT APPLICATION**

(43) Date of publication:
**12.04.2017 Bulletin 2017/15**

(51) Int Cl.:
***H03H 7/09*** *(2006.01)* ***H03H 7/01*** *(2006.01)*

(21) Application number: **15188303.0**

(22) Date of filing: **05.10.2015**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(71) Applicant: **Huawei Technologies Co., Ltd.
Longgang District
Shenzhen, Guangdong 518129 (CN)**

(72) Inventors:
• **MACPHAIL, Philip
16440 Kista (SE)**

• **LEHTINEN, Teijo
16440 Kista (SE)**

(74) Representative: **Thun, Clemens
Mitscherlich PartmbB
Patent- und Rechtsanwälte
Sonnenstraße 33
80331 München (DE)**

Remarks:
Amended claims in accordance with Rule 137(2)
EPC.

(54) **ELECTRIC FILTER COMPRISING A TRANSFORMER**

(57) The invention provides a filter (100), comprising a first transformer (110), a first capacitor (120) which is connected in series with a first winding (112) of the first transformer (110), and a second capacitor (130) which is connected in parallel with a second winding (114) of the first transformer (110).

FIG. 1B

**Description**

**TECHNICAL FIELD**

The present invention relates to a filter, a composite filter and a multi-stage filter.

**BACKGROUND**

Differential circuits offer many performance advantages in both analogue and RF systems, but the resulting complexity often discourages their use. The industry trend of moving from discrete circuit design to integrated solutions is challenging this position, requiring new implementation methods of established designs to make the most of this transition.

A simple elliptic filter topology that has been used for many years has two independent filtering characteristics that combine to make a deceptively complex filter. In particular, two L-C shunt networks can produce two notches (or transmission zeroes) in the frequency response, and at some intermediate frequency they also create a pole. The pole ensures that the insertion loss of the filter is minimized while the zeroes provide high attenuation close to this center-frequency, however, the wide-band attenuation is low and the passband is not very flat. These two deficiencies can be addressed by series-resonant networks at each end of the filter.

The basic principle of such filters is that an inductor-capacitor pair, $L_2$ and $C_2$, creates a zero in the frequency response at frequency $F_1$, and a further inductor-capacitor pair, $L_3$ and $C_3$, creates a zero at frequency $F_2$. At a frequency $F_0$ between these two zeroes one combination is inductive, the other capacitive, and a pole is produced. Further pairs of capacitors and inductances are tuned to the same frequency to broaden the passband. For the case here $F_0$, $F_1$ and $F_2$ are defined and the values of the inductances and capacitors can be calculated from these terms.

Conventional solutions exhibit several deficiencies. For example, the filter topology cannot easily be converted to a differential design, and when doing so the size of the filter doubles. The increased number of inductors also raises the problem that a coupling between them can affect the frequency response. Furthermore, to produce significant attenuation away from the passband, the series inductors in the through-path are required to be large in value. This limits the frequency range of the filter and increases the difficulty in designing the inductors to prevent self-resonance distorting the frequency response. Furthermore, a production cost of such filters may be high.

**SUMMARY OF THE INVENTION**

The objective of the present invention is to provide a filter which overcomes one or more of the above-mentioned problems.

A first aspect of the invention provides a filter, comprising a first transformer, a first capacitor which is connected in series with a first winding of the first transformer, and a second capacitor which is connected in parallel with a second winding of the first transformer.

Advantageously, the filter of the first aspect achieves a frequency response that is the same or very similar as a traditional network of separate inductors, but with a much smaller required area.

In a first implementation of the filter according to the first aspect, the second capacitor is a floating capacitor. Or in other words, the capacitor is left floating (e. g. not connected to ground or any other voltage terminal).

This has the advantage that the filter of the first aspect can be implemented particularly simply, with few components.

In a second implementation of the filter according to the first aspect, the first capacitor has a first capacitance

$$C_1 = \frac{1}{\omega_1^2 L_p}$$

and/or the second capacitor has a second capacitance

$$C_2 = \frac{1}{\omega_0^2 L_s}$$

with a mutual inductance M between $L_p$ and $L_s$

$$M = \sqrt{L_p L_s - \left(\frac{\omega_0}{\omega_2}\right)^2 L_s^2}$$

wherein $\omega_0$ is the frequency of a pole of a frequency response of the filter, $\omega_1$ is the frequency of a lower zero of the frequency response, $\omega_2$ is the frequency of an upper zero of the frequency response, $L_p$ is the inductance of the first winding and $L_s$ is the inductance of the second winding.

By using the above settings of capacitance and mutual inductance as defined above, the filter of the second implementation can be configured to achieve the desired passband over a large range of frequencies, wherein the filter has a single-ended design.

It is understood that in the above equation and further equations below, the values for the capacitances may need to be modified to account for parasitic capacitances. In other words, the values for $C_1$, $C_2$, and $C_3$ can be considered as composites of stray (parasitic) and real capacitances and this may need to be considered when choosing capacitors.

In a third implementation of the filter according to the first aspect, the filter further comprises a third capacitor, wherein the first capacitor is connected to a first terminal of the first winding and the third capacitor is connected to a second terminal of the first winding.

Thus, the first winding is in series with two capacitors and located between these two capacitors.

In a fourth implementation of the filter according to the third implementation, the first capacitor has a first capacitance $C_1$ and the third capacitor has a third capacitance $C_3$ such that

$$\frac{1}{C_1} + \frac{1}{C_3} = \omega_1^2 L_p$$

and/or the second capacitor has a second capacitance

$$C_2 = \frac{1}{\omega_0^2 L_s}$$

and/or a mutual inductance M between the first and the second winding is given by:

$$M = \sqrt{L_p L_s - \left(\frac{\omega_0}{\omega_2}\right)^2 L_s^2}$$

wherein $\omega_0$ is the frequency of a pole of a frequency response of the filter, $\omega_1$ is the frequency of a lower zero of the frequency response, $\omega_2$ is the frequency of an upper zero of the frequency response, $L_p$ is the inductance of the first winding and $L_s$ is the inductance of the second winding.

By using the above settings of capacitance and mutual inductance as defined above, the filter of the third implementation can be configured to achieve the desired passband over a large range of frequencies.

In a fifth implementation of the filter according to the first aspect, the filter is a differential filter and the first capacitor is connected to an upper (or first) branch of the differential filter and the third capacitor is connected to a lower (or second) branch of the differential filter, wherein the filter has a differential design.

The filter of the fifth implementation is advantageous because the space required for traditional filters with a differential design is particularly high. Thus, the savings achieved with a filter according to the fifth implementation are also particularly high.

A second aspect of the invention refers to a composite filter, comprising

- a first filter according to one of the previous implementations of the first aspect as such, and

- a second filter comprising a first capacitor, a second capacitor and a second transformer with a first winding and a second winding,

wherein the first winding of the second transformer is connected in parallel with the first capacitor of the second filter, and the second winding of the second transformer is connected in parallel with the second capacitor of the second filter,

wherein the second winding of the second transformer of the second filter is coupled to the first winding of the first transformer of the first filter via at least the first capacitor of the first filter.

A composite filter according to the second aspect has the advantage that a flat passband can be achieved with particularly low space requirements.

A third aspect of the invention refers to a multi-stage filter, comprising a first filter stage and a second filter stage, wherein the first filter stage comprises a first composite filter according to the second aspect, and/or the second filter stage comprises a second composite filter according to the second aspect, wherein the first filter stage is connected to a first winding of an intermediate transformer and the second filter stage is connected to a second winding of the intermediate transformer.

A multi-stage filter according to the third aspect has the advantage that the attenuation outside the passband can be increased even further.

In a first further implementation of a filter of the first, second or third aspect, the first and the second winding have inductances between 0,01 nH and 100 nH and/or the first and the second capacitor have capacitances between 0,01 pF and 100 pF.

In particular, the first and/or second winding can have inductances between 0,1 and 10 nH, preferably between 0,5 and 5 μH. The first and/or the second capacitor can have a capacitance between 0,05 pF and 5 pF, preferably between 0,1 pF and 1 pF. Experiments have shown that in these ranges particularly high space savings can be achieved with the presented filter design.

In a second further implementation of a filter of the first, second or third aspect, the filter is configured such that one or more zeroes and/or one or more poles of the filter are located in a frequency range between 1 GHz and 1 THz, preferably between 3 GHz and 300 GHz. Preferably, all zeroes and/or all poles of the filter are located in the mentioned frequency range.

Experiments have shown that in these frequency ranges particularly high space savings can be achieved with the presented filter design compared to conventional filter designs.

In a third further implementation of a filter of the first, second or third aspect, the first and/or the second winding of the first transformer comprise one or more tracks of a printed circuit board.

In particular, the first and/or second winding of the first transformer can be completely implemented as one or more tracks of a printed circuit board.

The filter of the third further implementation of the first, second or third aspect has the advantage that it can be implemented with particularly small space requirements and/or with particularly small production costs. In particular, the production cost can be reduced because the transformer does not need to be mounted on the printed circuit board, but can be built into the printed circuit board during the production of the printed circuit board.

In a fourth further implementation of a filter of the first, second or third aspect, the one or more tracks of the first winding and the one or more tracks of the second winding are arranged concentrically.

This provides a particularly efficient way of implementing the windings of the transformer on the printed circuit board.

In a fifth further implementation of a filter of the first, second or third aspect, the tracks of the first and/or the second winding comprise two individual windings which comprise at least one crossing between different layers of the printed circuit board.

This has the advantage that first and second winding can be located particularly close to each other, thus achieving a high mutual inductance.

**BRIEF DESCRIPTION OF THE DRAWINGS**

To illustrate the technical features of embodiments of the present invention more clearly, the accompanying drawings provided for describing the embodiments are introduced briefly in the following. The accompanying drawings in the following description merely show some embodiments of the present invention, but modifications on these embodiments are possible without departing from the scope of the present invention as defined in the claims.

FIG. 1A is a block diagram illustrating a filter in accordance with an embodiment of the present invention,

FIG. 1B is a circuit diagram illustrating a further filter in accordance with a further embodiment of the present invention,

FIG. 1C is a circuit diagram illustrating an equivalent circuit of the filter of FIG. 1B,

FIG. 2 is a circuit diagram illustrating a single-ended composite filter in accordance with a further embodiment of the present invention,

FIG. 3 is a circuit diagram illustrating a differential composite filter in accordance with an embodiment of the present invention,

FIG. 4 is a circuit diagram illustrating a multi-stage filter in accordance with a further embodiment of the present invention,

FIG. 5 is a diagram illustrating the frequency response of a filter in accordance with an embodiment of the present invention, and

FIG. 6 shows a schematic illustration of tracks of a printed circuit board transformer that is used in a filter in accordance with a further embodiment of the present invention.

Detailed Description of the Embodiments

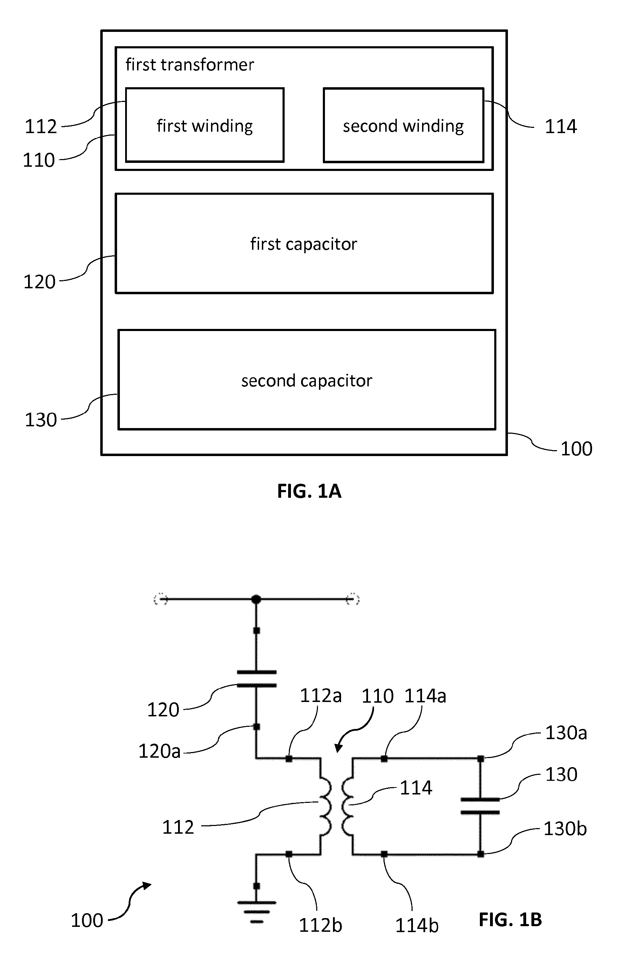

FIG. 1A is a schematic diagram of a filter 100 in accordance with an embodiment of the present invention. The filter 100 comprises a first transformer 110, a first capacitor 120, and a second capacitor 130. The first transformer 110 has a first winding 112 and a second winding 114, wherein the first capacitor 110 is connected in series with a first winding of the first transformer 110 and the second capacitor 130 is connected in parallel with a second winding 114 of the first transformer 110.

The design of the filter of FIG. 1A will work equally well in a differential design and a single-ended design. The advantage of reduced number of inductors (and therefore space-saving) is maintained in both cases.

FIG. 1B is a circuit diagram of a further filter 100 in accordance with a further embodiment of the present invention. The filter 100 of FIG. 1B comprises a transformer 110 and a first and second capacitor 120, 130. The first transformer 110 has a first winding 112 and a second winding 114. The first winding 112 has a first terminal 112a, which is directly connected to a terminal 120a of the first capacitor. In other embodiments of the invention, further components might be located between the first terminal 112a and the first capacitor 120. For example, one or more resistors, one or more further capacitors and/or one or more further inductances could be located between the first terminal 112a and the first capacitor 120. A second terminal 112b of the first winding 112 is connected to ground.

The second winding 114 has a first terminal 114a and a second terminal 114b, which are directly connected to a first and second terminal 130a, 130b of a second capacitor 130. The second capacitor 130 is not connected to any further components. Hence, the second capacitor 130 can be regarded as floating capacitor 130.

A transformer in accordance with the embodiments of the present invention has two or more windings that have a magnetic coupling between them. This coupling can be described as either a coupling factor or mutual inductance, wherein the relationship between them is given by

$$k = \frac{M}{\sqrt{L1 * L2}}$$

where k is coupling factor, and M is mutual inductance.

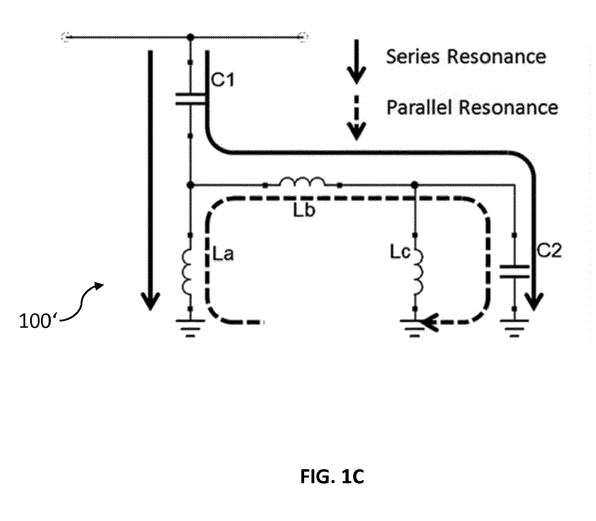

As illustrated in the equivalent circuit diagram 100' shown in FIG. 1C, the transformer of the circuit of FIG. 1B can be expressed as an equivalent network of a first effective coil inductances $L_a$, a second effective coil inductance $L_c$ and a leakage inductance $L_b$ between them. If it is assumed that a capacitance $C_1$ of the first capacitor is significantly larger than a capacitance $C_2$ of the second capacitor, then one resonance is formed by $C_2$ and the parallel combination of $L_c$ and $L_b$. A second one is produced by $C_1$ and $L_p$, the primary inductance of the transformer. In reality, $C_1$ will reduce the effective value of $C_2$, and $C_2$ will increase the equivalent value of $L_2$ and $L_3$, so the zeroes will be spaced further from the passband than intended.

Obtaining the transformer characteristics can be done as follows:

$L_1$ in the filter schematic is equivalent to $L_a$ in the equivalent transformer model, as both resonate with $C_1$ to produce a low-side notch at $F_0$.

Filter $L_2$ is equivalent to transformer $L_c$ in parallel with $L_b$, Given primary inductance $L_p$ and secondary inductance $L_s$ -

$$L_b = \frac{L_p L_s - M^2}{M}$$

$$L_c = \frac{L_p L_s - M^2}{L_s - M}$$

Then the filter $L_2$ can be expressed in parameters of the transformer -

$$Filter\_L_2 = \frac{L_p L_s - M^2}{L_s}$$

The capacitor that resonates with Filter_$L_2$ to make the high-frequency zero also resonates with $L_s$ to make a pole at the centre-frequency of the filter (this completes the mapping of the L-C circuit onto the transformer topology). This defines the following relationship -

$$Filter\_L_2 = \left(\frac{\omega_0}{\omega_2}\right)^2 L_s$$

And then -

$$M = \sqrt{L_p L_s - \left(\frac{\omega_0}{\omega_2}\right)^2 L_s^2}$$

The design procedure becomes a process of selecting $L_p$ and $L_s$, and choosing the coupling factor based on the equations above. $C_2$ is found by resonating Filter_$L_2$ at the upper notch frequency, and $C_1$ found by resonating $L_p$ at the lower notch frequency.

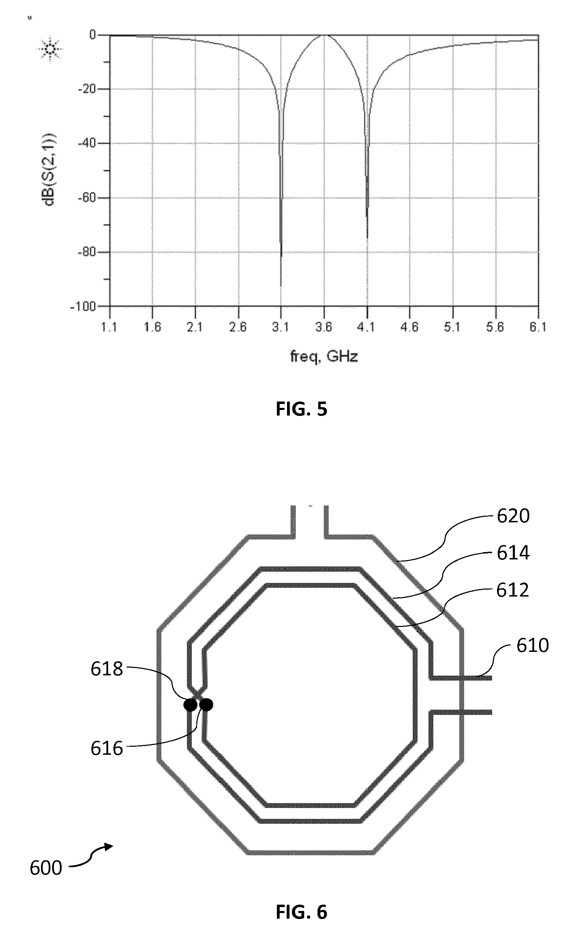

Due to the above equivalence, the frequency response of the network of FIG. 1B corresponds to the frequency response of a network of shunt inductors in conventional systems, as illustrated further below in FIG. 5.

The filters of FIG. 1A and FIG. 1B can also be used in a mixed environment, with one port differential and the other single-ended (balun or unbal).

The number of stages can be increased to increase attenuation outside the passband, wherein preferably the series and shunt elements are duplicated in pairs.

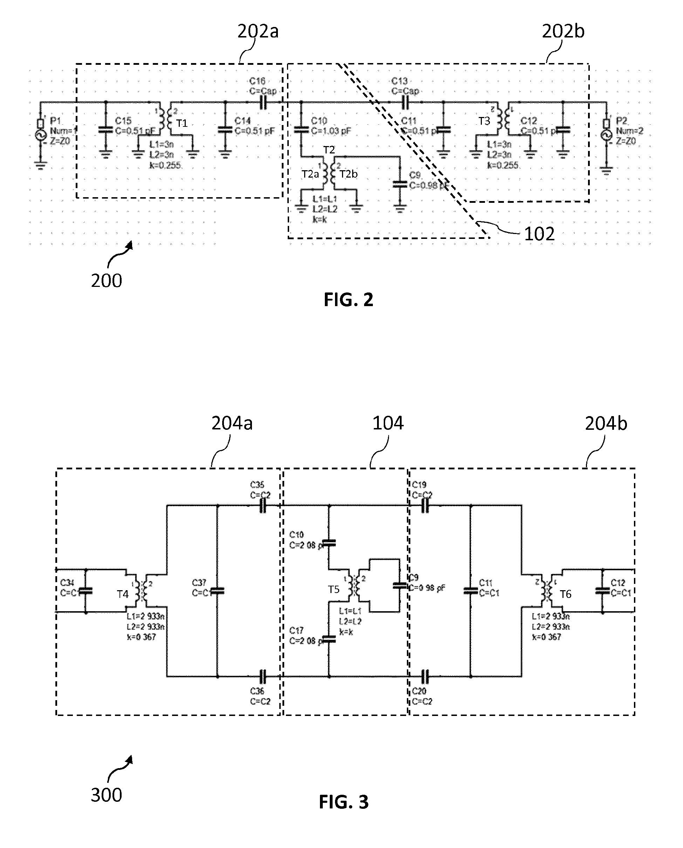

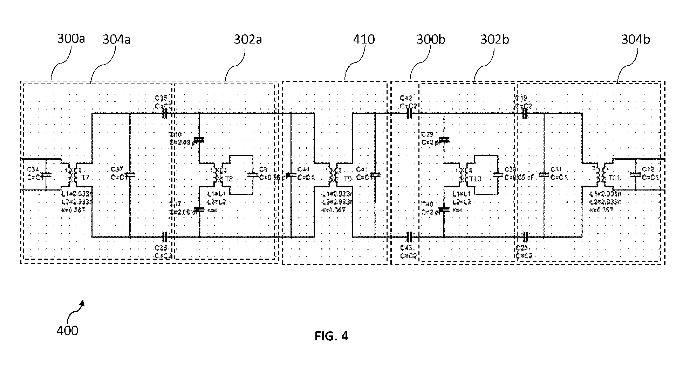

The embodiments described below illustrate several implementations, starting with a single-ended design in FIG. 2 using transformers to implement the inductors. FIG. 3 shows a fully differential version of the filter, and FIG. 4 demonstrates the extensibility of the concept by adding further pole-zero combinations to the filter.

FIG. 2 is a circuit diagram illustrating a single-ended composite filter 200 in accordance with an embodiment of the present invention. The composite filter 200 comprises a centrally located first filter 102, a left second filter 202a, and a right second filter 202b.

In this embodiment and the further embodiments below, also the series inductances of a traditional network are replaced by suitable transformer circuits.

The first filter 102 comprises a transformer T2 with a first winding T2a and a second winding T2b. Both the first winding T2a and the second winding T2b have a first terminal which is connected to ground. A second terminal of the first winding T2b is connected in series with a first terminal of a first capacitor C10. A second terminal of the second winding T2b is connected to a second capacitor C9 of the first filter 102.

In an example embodiment, the values of capacitors C9 and C10 of the first filter 102 are given as $C_{10}$=1,03 pF and $C_{09}$=0,98 pF.

A second terminal of the first capacitor C10 is connected with a terminal of the left second filter 202a and a terminal of the right second filter 202b.

The left second filter 202a comprises a first capacitor C15, a transformer T1, a second capacitor C 14 and a further capacitor C16. The first capacitor C15 is connected in parallel to a first winding of the transformer T1, the second capacitor C 14 is connected in parallel with a second winding of the transformer T1. A first terminal of the first winding and a first terminal of the second winding of the transformer T 1 are connected to ground, and a second terminal of the second winding is connected with a first terminal of the further capacitor C16. A second terminal of the further capacitor C16 is connected to the centrally located first filter 102 (in detail: to the second terminal of the first capacitor C10 of the first filter 102).

In an example embodiment, the capacitors of the left second filter have the following values: $C_{14}$=0,51 pF, $C_{15}$=0,51 pF, $C_{16}$=0,1925 pF.

The right second filter 202b comprises a first capacitor C12, a transformer T3, a second capacitor C11 and a further capacitor C13. The first capacitor C12 is connected in parallel to a first winding of the transformer T3, the second capacitor C11 is connected in parallel with a second winding of the transformer T3. A first terminal of the first winding and a first terminal of the second winding of the transformer T3 are connected to ground, and a second terminal of the second winding is connected with a first terminal of the further capacitor C13. A second terminal of the further capacitor C13 is connected to the centrally located first filter 102 (in detail: to the second terminal of the first capacitor C10 of the first filter 102).

In an example embodiment, the capacitors of the left second filter have the following values: $C_{11}$=0,51 pF, $C_{12}$=0,51 pF, $C_{13}$=0,1925 pF.

The high values of inductance required to make this filter possible at high frequencies are not practical as real inductors, however it has been found by the inventor that using the leakage inductance of a transformer this topology becomes practical.

A transformer with finite coupling can be modeled as a pi-network of inductors. For this application $L_b$ is the desired term, and the shunt inductors $L_a$ and $L_c$ can be compensated by resonating them with capacitors.

$L_b$ is the wanted term, while $L_p$ and $L_s$ (primary and secondary inductances) are chosen arbitrarily, and can also be used to provide an impedance transformation into and out of the filter. From this M can be calculated, and all other parameters derived from this.

$$M = \frac{\sqrt{L_b{}^2 + 4L_p L_s} - L_b}{2}$$

$$T = -M^2 + L_p L_s$$

$$L_a = {}^T\!/_{\left(L_p - M\right)}$$

$$L_c = {}^T\!/_{\left(L_s - M\right)}$$

$$k = \frac{M}{\sqrt{L_p L_s}}$$

$L_a$ and $L_b$ are resonated with shunt capacitors, and $L_b$ resonated with a series capacitor.

In an example embodiment, the inductances of the first and second winding of transformer T1 and T3 are 0,1 nH with a coupling factor $k$=0,255. The inductances of the first and second winding of transformer T2 are 0,2 nH, with a coupling factor $k$=0,231.

The composite filter 200 of FIG. 2 can be connected to a first (input/output) port P1 and a second (input/output) port P2.

FIG. 3 is a circuit diagram illustrating a differential composite filter 300 in accordance with a further embodiment of the present invention. The differential composite filter 300 comprises a left second filter 204a, a right second filter 204b, and a central filter 104.

The central filter 104 comprises a transformer T5, a first capacitor C10 and a third capacitor C17 which are connected in series with a first winding of the transformer T5, and a second capacitor C9, which is connected to a second winding of the transformer T5. The floating second capacitor C9 is not connected to any further components and, hence, can be regarded as floating capacitor C9.

The left second filter 204a comprises a first capacitor C34, a transformer T4, a second capacitor C37 and two further capacitors C35, C36. The first capacitor C34 is connected in parallel with a first winding of the transformer T14 of the left second filter. The second capacitor C37 is connected in parallel with a second winding of the transformer T14.

The right second filter 204b comprises capacitors C11, C12, C19 and C20, as well as a transformer T6. The right second filter is essentially structured in the same way as the left second filter 204a.

The composite filter 300 of FIG. 3 is a differential filter. It comprises an upper path which passes from an upper terminal of the second winding of transformer T4 through capacitor C35, capacitor C 19 to an upper terminal of the second winding of the transformer T6. The filter 300 further comprises a lower path which passes from a lower terminal of the second winding of transformer T4 through capacitor C36, capacitor C20 to a lower terminal of the second winding of the transformer T6. The lower path comprises between C36 and C20 a connection to the third capacitor C17 of the central filter 104. The upper path comprises between C35 and C19 a connection to the first capacitor C10 of the central filter 104.

FIG. 4 is a circuit diagram illustrating a multi-stage filter 400 in accordance with a further embodiment of the present invention. The multi-stage filter 400 comprises a first stage filter 300a, which is a first composite filter, an intermediate part 410 comprising an intermediate transformer T9 and a second stage filter 300b, which is a second composite filter.

The first composite filter 300a comprises a first filter 302a and a second filter 304a. The first filter 302a comprises a transformer T8 and a first capacitor C10, a second capacitor C9 and a third capacitor C 17. The wiring between these components corresponds to the wiring of the first filter 104 of FIG. 3. The second filter 304a comprises a transformer T7 and a first capacitor C34 and a second capacitor C37 of the second filter 304a. The second filter 304a further comprises two further capacitors C35, C36, which connect the terminals of the transformer T7 with the first filter 302a.

The second composite filter 300b is structured similarly as the first composite filter 300a, but further comprises capacitors C42, C43 between the first filter and the intermediate filter 410.

The intermediate filter 410 comprises an intermediate transformer T9 and capacitors C41, C44, which are connected in parallel with the first and second winding of the intermediate transformer T9.

In an example embodiment, the components of the multi-stage filter of FIG. 4 have the following values:

$C_{34}$, $C_{37}$, $C_{44}$, $C_{41}$, $C_{11}$, and $C_{12}$ have the same first capacitance value, wherein the first capacitance value is between 0,1 pF and 1 pF, preferably between 0,2 pF and 0,5 pF.

$C_{19}$, $C_{20}$, $C_{35}$, $C_{36}$, $C_{42}$, and $C_{43}$ have the same second capacitance value, wherein the second capacitance value is between 0,1 pF and 1 pF, preferably between 0,2 pF and 0,5 pF.

$C_{17}$ and $C_{10}$ have capacitance values between 0,5 and 5 pF, preferably 2,08 pF.

The transformers T7 to T11 preferably have inductance values of 1 nH and 10 nH, and a mutual inductance factor *k* between 0,2 and 0,5, preferably 0,367.

FIG. 5 is a diagram illustrating the frequency response of a filter according to FIG. 1B. It can be seen that the frequency response of this network corresponds to the frequency response of a network of shunt inductors in conventional systems, however the required area is reduced as the transformer primary and secondary are overlapped.

FIG. 6 shows a schematic illustration of tracks of a printed circuit board transformer 600 of a further filter in accordance with a further embodiment of the present invention. The printed circuit board transformer 600 comprises a first winding 610 and a second winding 620. The first winding comprises an inner part 612 which in this embodiment is a track on a first layer of the printed circuit board. The first winding further comprises an outer part 614 which is a track on a second layer of the printed circuit board. The inner part 612 comprises a crossing 616 from the first layer to the second layer, and the outer part 614 comprises a crossing 618 from the second layer to the first layer.

The second winding 620 is completely arranged on the first layer. Thus, a transformer with characteristics suitable for use in a filter in accordance with embodiments of the present invention can be implemented with low space requirements and low production cost (since a separate transformer device is not necessary).

In a preferred embodiment, the first layer is a lower layer and the second layer is an upper layer of the printed circuit board.

In further embodiments of the invention, also the first, second and/or third capacitor are realized as one or more tracks of the printed circuit board.

To summarize, embodiments of the invention relate to a filter topology comprising a transformer and corresponding circuitry around so that a series resonance (a pole in the frequency response) and two parallel resonances (two zeroes in the frequency response) are generated.

Relevant points of embodiments of the present invention include:

- Terminals of a transformer can be connected in such a way that a combination of zeroes and poles can be realized, resulting in a complex filter.

- The use of a transformer effectively overlays two inductors in a single space. The resulting coupling between the coils is used as a design component, rather than an impairment that needs to be minimized.

- The leakage inductance between transformer windings can be used to synthesize otherwise impossibly large inductor values. The combination of the two circuit 'tricks' (transformer as complex filter and synthesizing large inductances by means of transformer mutual inductance) can permit the design of compact filters, and can be used in balun, unbal, unun and balbal combinations.

The foregoing descriptions are only implementation manners of the present invention, the protection of the scope of the present invention is not limited to this. Any variations or replacements can be easily made through person skilled in the art. Therefore, the protection scope of the present invention should be subject to the protection scope of the attached claims.

**Claims**

1. A filter (100; 102; 104; 200; 300, 302a, 302b; 400), comprising a first transformer (110; T2; T5; T8; T10), a first capacitor (120; C10, C39) which is connected in series with a first winding (112, T2a) of the first transformer, and a second capacitor (130; C9; C38) which is connected in parallel with a second winding (114, T2b) of the first transformer.

2. The filter of claim 1, wherein the second capacitor is a floating capacitor (130; C9, C38).

3. The filter of one of the previous claims, wherein the first capacitor (120; C10, C39) has a first capacitance

$$C_1 = \frac{1}{\omega_1^2 L_p}$$

and/or wherein the second capacitor (130; C9; C38) has a second capacitance

$$C_2 = \frac{1}{\omega_0^2 L_s}$$

and/or wherein a mutual inductance M between the first and the second winding is given by

$$M = \sqrt{L_p L_s - \left(\frac{\omega_0}{\omega_2}\right)^2 L_s^2}$$

wherein $\omega_0$ is the frequency of a pole of a frequency response of the filter, $\omega_1$ is the frequency of a lower zero of the frequency response, $\omega_2$ is the frequency of an upper zero of the frequency response, $L_p$ is the inductance of the first winding and $L_s$ is the inductance of the second winding.

4. The filter of one of claims 1 and 2, further comprising a third capacitor (C17, C40), wherein the first capacitor is connected to a first terminal (112a) of the first winding and the third capacitor is connected to a second terminal (112b) of the first winding.

5. The filter of claim 4, wherein the first capacitor (120; C10, C39) has a first capacitance $C_1$ and the third capacitor (C17, C40) has a third capacitance $C_3$ such that

$$\frac{1}{C_1} + \frac{1}{C_3} = \omega_1^2 L_p$$

and/or wherein the second capacitor has a second capacitance

$$C_2 = \frac{1}{\omega_0^2 L_s}$$

and/or wherein a mutual inductance M between the first and the second winding is given by:

$$M = \sqrt{L_p L_s - \left(\frac{\omega_0}{\omega_2}\right)^2 L_s^2}$$

wherein $\omega_0$ is the frequency of a pole of a frequency response of the filter, $\omega_1$ is the frequency of a lower zero of the frequency response, $\omega_2$ is the frequency of an upper zero of the frequency response, $L_p$ is the inductance of the first winding and $L_s$ is the inductance of the second winding.

6. The filter of claim 4 or 5, wherein the filter is a differential filter (104, 300, 302a, 302b; 400) and wherein the first capacitor is connected to an upper branch of the differential filter and the third capacitor is connected to a lower branch of the differential filter.

7. A composite filter (200; 300, 302a, 302b; 400), comprising

   - a first filter (102; 104; 302a, 302b) according to one of the previous claims, and
   - a second filter (202a, 202b; 204a, 204b; 304a, 304b) comprising a first capacitor, a second capacitor, and a second transformer (T1, T3; T4, T6; T7, T11) with a first winding and a second winding, wherein the first winding of the second transformer is connected in parallel with the first capacitor of the second second filter, and the second winding of the second transformer is connected in parallel with the second capacitor of the second filter,

   wherein the second winding of the second transformer of the second filter is coupled to the first winding of the first transformer of the first filter via at least the first capacitor of the first filter.

8. A multi-stage filter (400), comprising a first filter stage (300a) and a second filter stage (300b), wherein the first filter stage comprises a first composite filter according to claim 7 and/or the second filter stage comprises a second composite filter according to claim 7, wherein the first filter stage is connected to a first winding of an intermediate transformer (T9) and the second filter stage is connected to a second winding of the intermediate transformer.

9. The multi-stage filter according to claim 8, further comprising an intermediate filter (410) which comprises the intermediate transformer (T9), wherein the first winding of the intermediate transformer is connected in parallel with a first capacitor (C44) of the intermediate filter and the second winding of the intermediate transformer is connected in parallel with a second capacitor (C41) of the intermediate filter.

10. The filter of one of the previous claims, wherein the first and the second winding have inductances between 0,05 μH and 50 μH and/or the first and the second capacitor have capacitances between 0,05 pF and 50 pF.

**11.** The filter of one of the previous claims, wherein the filter is configured such that one or more zeroes and/or one or more poles of the filter are located at frequencies between 1 GHz and 1 THz, preferably between 3 GHz and 300 GHz.

**12.** The filter of one of the previous claims, wherein the first winding (610) and/or the second winding (620) of the first transformer (600) comprise one or more tracks (610-620) of a printed circuit board.

**13.** The filter of claim 12, wherein the one or more tracks (610, 612, 614) of the first winding and the one or more tracks (620) of the second winding are arranged concentrically.

**14.** The filter of claim 12 or 13, wherein the tracks of the first and/or the second winding comprise two individual windings (612, 614) which comprise at least one crossing (616, 618) between different layers of the printed circuit board.


**Amended claims in accordance with Rule 137(2) EPC.**

**1.** A filter (100; 102; 104; 200; 300, 302a, 302b; 400), comprising a first transformer (110; T2; T5; T8; T10), a first capacitor (120; C10, C39) which is connected in series with a first winding (112, T2a) of the first transformer, and a second capacitor (130; C9; C38) which is connected in parallel with a second winding (114, T2b) of the first transformer, further comprising a third capacitor (C 17, C40), wherein the first capacitor is connected to a first terminal (112a) of the first winding and the third capacitor is connected to a second terminal (112b) of the first winding, wherein the first capacitor (120; C10, C39) has a first capacitance $C_1$ and the third capacitor (C17, C40) has a third capacitance $C_3$ such that

$$\frac{1}{C_1} + \frac{1}{C_3} = \omega_1^2 L_p$$

wherein $\omega_1$ is the frequency of a lower zero of a frequency response, and $L_p$ is the inductance of the first winding.

**2.** The filter of claim 1, wherein the second capacitor is a floating capacitor (130; C9, C38).

**3.** The filter of claim 1 or 2, wherein the filter is a differential filter (104, 300, 302a, 302b; 400) and wherein the first capacitor is connected to an upper branch of the differential filter and the third capacitor is connected to a lower branch of the differential filter.

**4.** A composite filter (200; 300, 302a, 302b; 400), comprising

    - a first filter (102; 104; 302a, 302b) according to one of the previous claims, and
    - a second filter (202a, 202b; 204a, 204b; 304a, 304b) comprising a first capacitor, a second capacitor, and a second transformer (T1, T3; T4, T6; T7, T 11) with a first winding and a second winding, wherein the first winding of the second transformer is connected in parallel with the first capacitor of the second second filter, and the second winding of the second transformer is connected in parallel with the second capacitor of the second filter,

wherein the second winding of the second transformer of the second filter is coupled to the first winding of the first transformer of the first filter via at least the first capacitor of the first filter.

**5.** A multi-stage filter (400), comprising a first filter stage (300a) and a second filter stage (300b), wherein the first filter stage comprises a first composite filter according to claim 4 and/or the second filter stage comprises a second composite filter according to claim 4, wherein the first filter stage is connected to a first winding of an intermediate transformer (T9) and the second filter stage is connected to a second winding of the intermediate transformer.

**6.** The multi-stage filter according to claim 5, further comprising an intermediate filter (410) which comprises the intermediate transformer (T9), wherein the first winding of the intermediate transformer is connected in parallel with a first capacitor (C44) of the intermediate filter and the second winding of the intermediate transformer is connected in parallel with a second capacitor (C41) of the intermediate filter.

**7.** The filter of one of the previous claims, wherein the first and the second winding have inductances between 0,05 $\mu$H and 50 $\mu$H and/or the first and the second capacitor have capacitances between 0,05 pF and 50 pF.

**8.** The filter of one of the previous claims, wherein the filter is configured such that one or more zeroes and/or one or more poles of the filter are located at frequencies between 1 GHz and 1 THz, preferably between 3 GHz and 300 GHz.

**9.** The filter of one of the previous claims, wherein the first winding (610) and/or the second winding (620) of the first transformer (600) comprise one or more tracks (610-620) of a printed circuit board.

**10.** The filter of claim 9, wherein the one or more tracks (610, 612, 614) of the first winding and the one or more tracks (620) of the second winding are arranged concentrically.

11. The filter of claim 9 or 10, wherein the tracks of the first and/or the second winding comprise two individual windings (612, 614) which comprise at least one crossing (616, 618) between different layers of the printed circuit board.

**FIG. 1A**

**FIG. 1B**

FIG. 1C

**FIG. 2**

**FIG. 3**

FIG. 4

**FIG. 5**

**FIG. 6**

Europäisches
Patentamt

European
Patent Office

Office européen
des brevets

# EUROPEAN SEARCH REPORT

Application Number

EP 15 18 8303

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 715 531 A (LIU HAI-SHEN [TW] ET AL) 3 February 1998 (1998-02-03) * figure 1 * | 1-14 | INV. H03H7/09 ADD. H03H7/01 |
| X | US 2005/068126 A1 (MUTO AKIRA [JP]) 31 March 2005 (2005-03-31) * figure 5 * | 1-14 | |
| X | US 2015/244340 A1 (LEE TAO-YI [TW] ET AL) 27 August 2015 (2015-08-27) * paragraphs [0042] - [0043]; figure 4 * | 1-14 | |
| A | US 2015/056939 A1 (ONG BENG-HWEE [SG] ET AL) 26 February 2015 (2015-02-26) * figure 8 * | 7-11 | |

TECHNICAL FIELDS
SEARCHED        (IPC)

H03H
H01F
H02M

The present search report has been drawn up for all claims

| Place of search | Date of completion of the search | Examiner |
|---|---|---|
| The Hague | 1 April 2016 | Radomirescu, B-M |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

............................................................................

& : member of the same patent family, corresponding
    document

EPO FORM 1503 03.82 (P04C01)

# EP 3 154 194 A1

## ANNEX TO THE EUROPEAN SEARCH REPORT
## ON EUROPEAN PATENT APPLICATION NO.

EP 15 18 8303

This annex lists the patent family members relating to the patent documents cited in the above-mentioned European search report.
The members are as contained in the European Patent Office EDP file on
The European Patent Office is in no way liable for these particulars which are merely given for the purpose of information.

01-04-2016

| Patent document cited in search report | | Publication date | Patent family member(s) | | Publication date |
|---|---|---|---|---|---|
| US 5715531 | A | 03-02-1998 | NONE | | |
| US 2005068126 | A1 | 31-03-2005 | EP | 1521329 A1 | 06-04-2005 |
| | | | JP | 2005109951 A | 21-04-2005 |
| | | | KR | 20050031929 A | 06-04-2005 |
| | | | TW | I246223 B | 21-12-2005 |
| | | | US | 2005068126 A1 | 31-03-2005 |
| US 2015244340 | A1 | 27-08-2015 | TW | 201534051 A | 01-09-2015 |
| | | | US | 2015244340 A1 | 27-08-2015 |
| US 2015056939 | A1 | 26-02-2015 | CN | 104426574 A | 18-03-2015 |
| | | | US | 2015056939 A1 | 26-02-2015 |

EPO FORM P0459

For more details about this annex : see Official Journal of the European Patent Office, No. 12/82